(19) **Europäisches Patentamt**

**European Patent Office**

**Office européen des brevets**

(11) **EP 0 590 516 B1**

(12) # EUROPÄISCHE PATENTSCHRIFT

(45) Veröffentlichungstag und Bekanntmachung des Hinweises auf die Patenterteilung:
**01.03.2000  Patentblatt 2000/09**

(51) Int. Cl.$^7$: **H03G 3/30**, H03F 3/193

(21) Anmeldenummer: **93115333.2**

(22) Anmeldetag: **23.09.1993**

(54) **Spannungsgesteuerte Anordnung**

Voltage controlled device

Dispositif commandé en tension

(84) Benannte Vertragsstaaten:
**DE FR GB NL**

(30) Priorität: **29.09.1992 DE 4232508**

(43) Veröffentlichungstag der Anmeldung:
**06.04.1994  Patentblatt 1994/14**

(73) Patentinhaber:
**DaimlerChrysler Aerospace Aktiengesellschaft
89077 Ulm (DE)**

(72) Erfinder:
• **Ludwig, Michael, Dipl.-Ing.
D-89077 Ulm (DE)**
• **Feldle, Heinz-Peter, Dr.
D-89250 Senden (DE)**

(74) Vertreter: **Straub, Bernd et al
DaimlerChrysler AG,
Intellectual Property Managament
Sedanstr. 10 / Geb. 17
89077 Ulm (DE)**

(56) Entgegenhaltungen:
**US-A- 4 422 051**          **US-A- 4 464 632**

**Beschreibung**

Die Erfindung betrifft eine spannungsgesteuerte Anordnung nach dem Oberbegriff des Patentanspruchs 1.

Eine derartige Anordnung, bei welcher vier gleiche Transistoren zu zwei Differenzverstärkern zusammengesetzt sind, ist beispielsweise aus der US-A-4 464 632 bekannt. Je ein Transistor jedes Differenzverstärkers ist an seinem Steuereingang mit einer ersten konstanten Steuerspannung, die beiden anderen Transistoren sind an ihren Steuereingängen mit einer zweiten, einstellbaren Steuerspannung beaufschlagt. Ein Audio-Eingangssignal liegt an einem weiteren Differenzvestärker an, der die Betriebsströme durch die beiden erstgenannten Differenzverstärker variiert. Die Anordnung dient zur Lautstärkeeinstellung eines Audio-Signals.

In vielen Anwendungsfällen der Nachrichtentechnik, z. B. bei phasengesteuerten aktiven Antennen, die aus einer Vielzahl von einzelnen Strahlerelementen bestehen, ist es erforderlich, die Amplituden- und die Phasenlage eines elektrischen Signals unabhängig voneinander zu verstellen. Vielfach wird zusätzlich gefordert, daß diese voneinander unabhängige Verstellmöglichkeit in einem vorgebbaren Frequenzbereich vorhanden sein sollte.

Zur Verstellung der Phasenlage sind verschiedene passive sowie aktive Phasenstellglieder (Phasenschieber) bekannt.

Eine Verstellung der Amplitude ist möglich mit Hilfe spannungsgesteuerter Dämpfungsglieder und/oder mit spannungsgesteuerten Verstärkern. Diese Anordnungen haben insbesondere bei hohen Frequenzen, z. B. im GHz-Bereich, den Nachteil, daß sogenannte parasitäre Schaltungselemente, die an sich bekannt sind, die eigentlich gewünschte Schaltungsanordnung in unerwünschter Weise beeinflussen. Derartige parasitäre Schaltungselemente, z. B. parasitäre Kapazitäten bei einem Transistor, sind zum Teil durch die Herstellung bedingt und müssen daher von einem Anwender solcher Schaltungselemente berücksichtigt werden. Es ist möglich, solche parasitären Eigenschaften zumindest in einem vorgebbaren Bereich zu kompensieren und/oder bei möglichen Einstellvorgängen zu berücksichtigen. Derartige Abhilfemaßnahmen sind in nachteiliger Weise insbesondere bei hohen Frequenzen technisch aufwendig und daher kostenungünstig.

Aus der US-A-4 422 051 ist eine Schaltungsanordnung bekannt zum Komprimieren oder Expandieren des dynamischen Amplitudenbereiches eines Audio-Signales. Damit wird gleichzeitig ein während der Aufnahme oder Wiedergabe des Audio-Signales entstandenes Rauschen unterdrückt. Dabei werden zwei Differenzverstärker, die jeweils ein Paar von Transistoren enthalten, benutzt. In Jedem Paar sind Transistoren desselben Leitungstyps vorhanden. Die Paare unterscheiden sich jedoch durch den Leitungstyp der Transistoren.

Der Erfindung liegt die Aufgabe zugrunde, eine Spannungsgesteuerte Anordnung anzugeben, die insbesondere für hohe Frequenzen geeignet ist, und die in einem weiten Amplitudenbereich eine von der Phasenlage weitgehendst unabhängige Verstellung der Amplitude ermöglicht.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß als spannungsgesteuerte Stellelemente eine Vielzahl an sich bekannter Bauelemente verwendbar sind, beispielsweise Röhren- oder Halbleiterverstärkeranordnungen, Bipolar- oder Feldeffekt-oder sonstige Transistoren oder spannungsgesteuerte Dämpfungsglieder, z. B. als spannungsgesteuerte Widerstände geschaltete Feldeffekttransistoren, PIN-Dioden oder Varaktoren.

Ein zweiter Vorteil besteht darin, daß die Anordnung in monolithisch integrierter Bauweise herstellbar ist und damit kostengünstig in weitere Hoch-und/oder Höchstfrequenzschaltungen einfügbar ist.

Weitere Vorteile ergeben sich aus der nachfolgenden Beschreibung.

Die Erfindung beruht auf einer Kompensation der an sich störenden parasitären Eigenschaften solcher Stellelemente.

Bei der Kompensationsschaltung werden vier in allen elektrisch erwünschten sowie parasitären Eigenschaften möglichst gleiche spannungsgesteuerte Stellelemente, z. B. Feldeffekttransistoren (FETs), verwendet. Eine solche Auswahl der Stellelemente ist möglich, da diese z. B. auf einem gemeinsamen Halbleiterchip in einem gemeinsamen Herstellungsvorgang herstellbar sind und damit nahezu gleiche Eigenschaften besitzen oder einzeln herstellbar und anschließend mit Hilfe hochgenauer Meßverfahren auswählbar sind. Derart bezüglich der elektrischen Eigenschaften ausgewählte Stellelemente werden als gleich betrachtet.

Mit vier gleichen Stellelementen ist nun vorteilhafterweise eine (Kompensations-)Anordnung herstellbar, die symmetrisch ist bezüglich

- des (HF-)Eingangssignales,
- des (HF-)Ausgangssignales,
- des Gleich- und/oder Wechselspannungs-Steuersignales (Steuerspannung), sowie
- der Versorgungsspannung der Anordnung.

Mit einer solchen (Kompensation-)Anordnung, die bezüglich eines (HF-)Eingangssignales entweder als spannungsgesteuerter Abschwächer oder als spannungsgesteuerter Verstärker ausbildbar ist, sind nun in überraschender Weise die bei einem einzelnen Stellelement an sich störenden parasitären Eigenschaften, insbesondere im Hoch- oder Höchstfrequenzbereich, kompensierbar.

Die Erfindung wird im folgenden anhand von Ausführungsbeispielen näher erläutert unter Bezugnahme auf schematisch dargestellte Figuren. Es zeigen

FIG. 1    ein Prinzipschaltbild zur Erläuterung der Erfindung;

FIG. 2    ein Ersatzschaltbild zur Erläuterung der Schaltung entsprechend FIG.1;

FIG.3    ein Prinzipschaltbild für eine digital ansteuerbare Spannungsquelle.

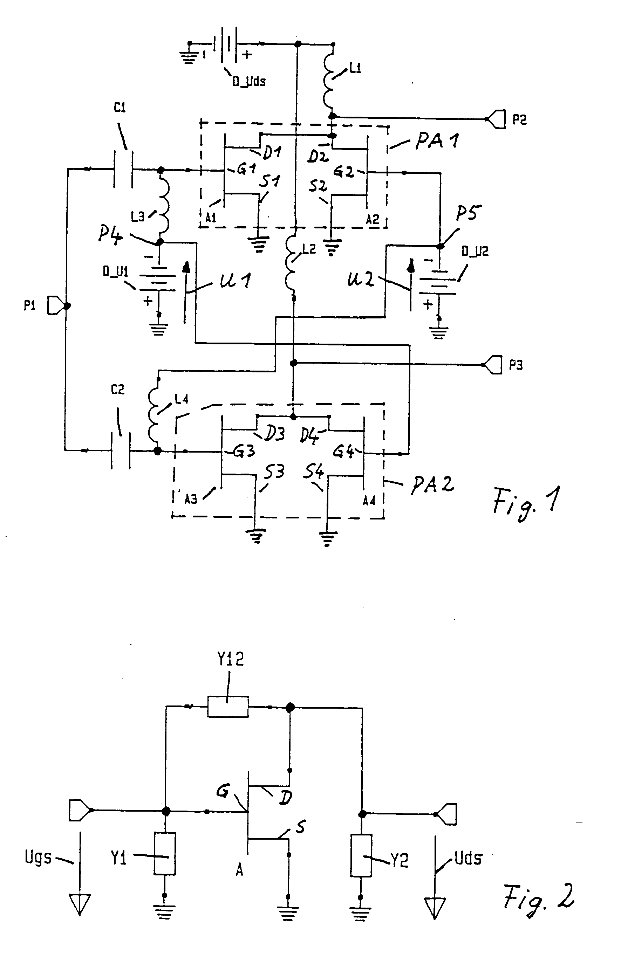

FIG. 1 zeigt die prinzipielle Schaltung eines spannungsgesteuerten Verstärkers, welcher beispielsweise für einen Frequenzbereich von 8 GHz bis 12 GHz (X-Band) geeignet ist und bei welchem die (Spannungs-)Verstärkung in einem weiten Bereich, z. B. 10 dB, nahezu unabhängig von der Frequenz und der Phasenlage durch eine Gleich- und/oder Wechsel-Steuerspannung änderbar ist. Dabei werden für die vier spannungsgesteuerten Stellelemente A1 bis A4 an sich gleiche Feldeffekttransistoren (FETs), die gleiche elektrische Eigenschaften besitzen und deren Grenzfrequenz sinnvollerweise wesentlich größer ist als die maximale Frequenz des gewünschten Frequenzbereiches, verwendet. Jeweils zwei der Stellelemente (FETs) A1, A2 sowie A3, A4 sind bezüglich der an den zugehörigen (komplementären) Signalausgängen P2 bzw. P3 auskoppelbaren (komplementären) (HF-)Ausgangssignale zu jeweils einem Paar PA1, PA2, zusammengefaßt. Jedes Paar besteht aus einem ersten Stellelement A1, A3 und einem zweiten Stellelement A2, A4. In jedem Paar PA1, PA2 ist jeweils ein erstes und ein zweites Stellelement zu einer Art Differenzschaltung zusammengeschaltet. Dieses erfolgt dadurch, daß bei allen Stellelementen A1 bis A4 die zugehörigen Source-Anschlüsse S1 bis S4 an die (HF-)Schaltungserde (HF-Masse) gelegt sind. Weiterhin sind die Drainanschlüsse D1 bis D4 paarweise, das heißt D1 mit D2 und D3 mit D4, galvanisch verbunden und einerseits nicht notwendigerweise galvanisch an den zu jedem Paar PA1, PA2 gehörenden (HF-)Signalausgang P2 bzw. P3 gelegt und andererseits über jeweils einen zugehörigen HF-Widerstand L1, L2 (HF-Drossel) an eine vorteilhafterweise gemeinsame Drain-Source-Spannungsquelle D_Uds gelegt, die z. B. eine Gleichspannung von drei Volt erzeugt. Ein an dem (HF-)Signaleingang P1 anliegendes (HF-)Eingangssignal wird über jeweils einen Koppelkondensator C1, C2 parallel an die Steuereingänge G1, G3 der ersten Stellelemente A1, A3 gelegt. An alle Steuereingänge G1 bis G4 wird außerdem mindestens eine Steuerspannung U1, U2 gelegt, die von mindestens einer Steuerspannungsquelle D_U1, D_U2 erzeugt wird. Diese Steuerspannung, die z. B. eine in Stufen schaltbare Gleichspannung von ungefähr ein Volt ist, dient zur Änderung der sogenannten Steilheit der Stellelemente A1 bis A4 und damit zur Änderung deren Verstärkungsfaktoren. Damit ist eine gewünschte Änderung der Amplitude des HF-Eingangssignales möglich.

Mit Hilfe der zwei Steuerspannungen U1, U2 werden nun jeweils zwei Stellelemente gesteuert. Dazu werden die zu den Paaren PA1, PA2 gehörenden Steuereingänge G1 bis G4 bezüglich der Steuerspannungen U1, U2 kreuzweise verbunden, das heißt, G1, G4 an U1 sowie G2, G3 an U2. Die zu den ersten Stellelementen A1, A3 führenden Steuerspannungen werden über HF-Induktivitäten L3 bzw. L4 (HF-Drosseln) an die Steuereingänge G1 bzw. G3 geleitet, damit ein Abfließen des an diesen Steuereingängen gleichzeitig anliegenden HF-Eingangssignals vermieden wird. Eine sinnvolle Abhängigkeit im vorliegenden Beispiel für U2 lautet: U2 = Up - U1  , was nachfolgend noch näher erläutert wird.

Bei solchen aus Transistoren, z. B. FETs, bestehenden spannungsgesteuerten Verstärkern wird die Verstärkung, und damit eine gewünschte Änderung der Amplitude eines HF-Eingangssignales, durch eine Änderung der Steilheit des Transistors eingestellt. Hierzu wird die im allgemeinen monotone Abhängigkeit der Steilheit von den Drain- oder Kollektorströmen, bzw. von den zugehörigen Gate- oder Basis-spannungen ausgenutzt. Mit derartigen Änderungen der Spannungen und/oder Ströme an einem Transistor werden auch in im allgemeinen unerwünschter Weise die parasitären Kapazitäten und Leitwerte sowie die internen Signal-Laufzeiten eines Transistors geändert. Diese störenden Änderungen führen an sich zu einer störenden Änderung der Phasenlage der Betriebsübertragungsfunktion des Verstärkers.

Diese störenden Eigenschaften werden bei dem für die Verwendung von Feldeffektransistoren (FETs) ausgelegten Beispiel einer Kompensationsschaltung gemäß FIG. 1 überwiegend vermieden. Eine weitgehende Kompensation ist möglich, wenn die zur Verstärkungsregelung nötigen Steuerspannungen U1, U2 so eingestellt werden, daß die Eingangs- sowie die Ausgangsadmittanz der Anordnung in dem gewählten Frequenz- und Amplitudenbereich der HF-Eingangs- und HF-Ausgangssignale im wesentlichen konstant sind.

Solche Ein- und Ausgangsadmittanzen sind erreichbar, was anhand der FIG. 2 erläutert wird. Diese zeigt ein Ersatzschaltbild eines realen Feldeffekttransistors. Dieser besteht aus einem idealen Feldeffekttransistor A, dessen Source-Anschluß mit der HF-Signalerde (HF-Masse) verbunden ist und der entsprechend seinen parasitären elektrischen Eigenschaften, insbesondere in dem gewählten Frequenz- und Amplitudenbereich, mit den zughörigen parasitären Admittanzen Y1, Y12, Y2 beschaltet ist. Die nichtlinearen Admittanzen Y1 (Eingangsadmittanz) und Y2 (Ausgangsadmittanz) sind für die Spannungsabhängigkeit durch eine Potenzreihe darstellbar. Wird diese unter der Annahme einer hinreichenden Linearität nach dem proportionalen (linearen) (Reihen-)Glied abgebrochen, so ergeben sich für eine konstante Drain-Source-Spannung (Uds = konstant) die Gleichungen

$$Y1 = Y10 + Y11 \cdot Ugs$$

$$Y1' = Y10 + Y11 \cdot (Up - Ugs)$$

$$Y1ges = Y1 + Y1' = 2Y10 + Y11 \cdot Up$$

$$Y2 = Y20 + Y21 \cdot Ugs$$

$$Y2' = Y20 + Y21 \cdot (Up - Ugs)$$

$$Y2ges = Y2 + Y2' = 2Y10 + Y11 \cdot Up,$$

wobei

Y1 = Eingangsadmittanz eines direkt mit Ugs gesteuerten Transistors A

Y1' = Eingangsadmittanz eines invers (Up-Ugs) gesteuerten Transistors A'

Y10 = konstantes Glied der Potenzreihe für die Eingangsadmittanz

Y11 = lineares Glied der Potenzreihe für die Eingangsadmittanz

Y1ges = Eingangsadmittanz der Parallelschaltung zweier Transistoren A, A'

Y2 = Ausgangsadmittanz eines direkt mit Ugs gesteuerten Transistors A

Y2' = Ausgangsadmittanz eines invers (Up-Ugs) mit Ugs gesteuerten Transistors A'

Y20 = kostantes Glied der Potenzreihe für die Ausgangsadmittanz

Y21 = lineares Glied der Potenzreihe für die Ausgangsadmittanz

Y2ges = Ausgangsadmittanz der Parallelschaltung zweier Transistoren A, A'

Ugs = Gate-Source-Spannung

Up = Abschnürspannung eines FETs

bedeuten.

Bei dieser Betrachtungsweise wird angenommen, daß die Spannungsabhängigkeit des Parameter Y12 = Rückwirkungsadmittanz gegenüber den übrigen Y-Parametern vergleichsweise klein und damit vernachlässigbar ist. Für den sogenannten Kleinsignalbetrieb ergeben sich damit in erster Näherung konstante Ein- und Ausgangsadmittanzen.

Mit diesen Bedingungen ist beispielsweise für das X- Band (8 GHz - 12 GHz) ein Verstärker entsprechend FIG. 1 herstellbar unter Verwendung geeigneter Anpaßschaltungen am Ein- und Ausgang, welcher eine Änderung der Verstärkung von ungefähr 10 dB ermöglicht, bei einer vernachlässigbaren Änderung der Phase von ± 1,9° und bei einer maximalen Verstärkung von ungefähr 7 dB. Für diesen Frequenzbereich ist das Stehwellenverhältnis am Signaleingang P1 und dem Signalausgang P2 kleiner als 1,8 : 1. Dabei ist der zweite Signalausgang P3, der invers (komplementär) zum ersten Signalausgang P2 arbeitet, reflexionsfrei abgeschlossen.

Die Steuerspannungen U1, U2 werden dabei in einem Bereich zwischen 0,25 Up und 0,9 Up geändert, wobei Up die Abschnürspannung eines FETs bedeutet. Zweckmäßigerweise lautet dann die Anhängigkeit für U2 von U1: U2 = Up - U1 .

Für das vorstehend erwähnte X-Band geeignete Feldeffekttransistoren haben in diesem Frequenzband beispielsweise folgende Ein- und Ausgangsadmittanzen:

Re (Y1(Ugs)) = 0,001 S      Re (Y2(Ugs)) = 0,02 S

Im (Y1(Ugs)) = 0,015 S      IM (Y2(Ugs)) = 0,01 S

bei einer Frequenz f = 10 GHz, einer Drain-Source-Spannung Uds = 7 V sowie einer Steuerspannung Ugs = - 0,65 V. Derartige Y-Parameter sind einem Fachmann geläufig und von Typ und/oder dem Exemplar des gewählten FETs abhängig, z. B. von dessen parasitären Kapazitäten.

Sollen mit dem in FIG. 1 beschriebenem Verstärker schnelle Änderungen, z. B. mit einer maximalen Frequenz von 100 MHz, der Amplituden der Ausgangssignale vorgenommen werden, so müssen die Steuerspannungen U1, U2 entsprechend schnell änderbar sein.

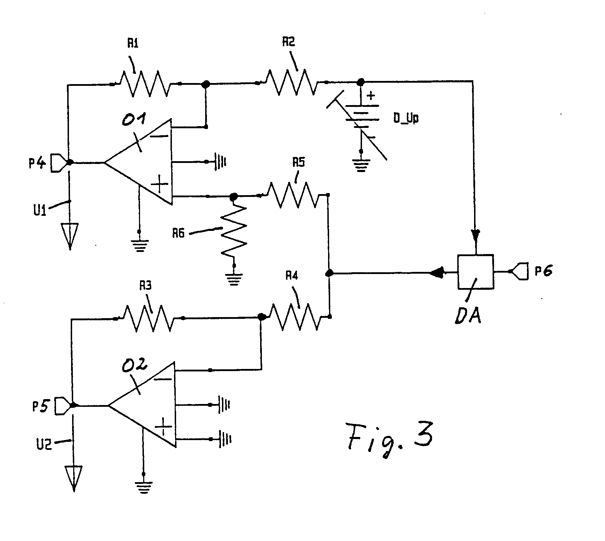

FIG. 3 zeigt beispielhaft eine schematische Anordnung zur Herstellung derartig schnell änderbarer Steuerspannungen U1, U2. Diese Anordnung enthält im wesentlichen zwei Operationsverstärker O1, O2, an deren Ausgängen P4, P5 die Steuerspannungen U1, U2 entstehen. Diese Ausgänge P4, P5 werden an die in FIG. 1 mit P4 und P5 bezeichneten Punkte angeschlossen und die in FIG. 1 dargestellten Steuerspannungsquellen D_U1 sowie D_U2 entfernt. In FIG. 3 ist der eine Operationsverstärker O1 als invertierender Verstärker beschaltet und der andere Operationsverstärker O2 als nichtinvertierender Verstärker. Bei dem dafür erforderlichen Netzwerk sind alle Widerstände R1 bis R6 gleich und haben z. B. einen Wert von 1 kΩ. Bei dem dargestellten Netzwerk sind die Widerstände R4 und R5 verbunden und an den Ausgang eines Digital/Analog-Wandlers DA angeschlossen. Dieser wirkt als einstellbare Referenz-Spannungsquelle für die Eingänge der Operationsverstärker O1, O2. Bei dem Digital/Analog-Wandler DA wird die maximal einstellbare Spannung vorgegeben durch die veränderbare Spannungsquelle D_Up. Mit dieser wird die für Feldeffekttransistoren charakteristische Abschnürspannung Up eingestellt, die von den Exemplarstreuungen der verwendeten Feldeffekttransistoren (A1 bis A4 in FIG.1) abhängt. Der Digital/Analog-Wandler besitzt einen digital ansteuerbaren Eingang P6, an den digitale Werte anlegbar sind. Diese können z. B. in einem nicht dargestellten digitalen Speicher gespeichert sein. Mit diesen gespeicherten Werten sind weitere Kompensationen möglich, z. B. ein Ausgleichen nichtlinearer Verstärkerkennlinien der Stellelemente A1 bis A4 (FETs in FIG. 1).

Die Erfindung ist nicht auf die beschriebenen Ausführungsbeispiele beschränkt, sondern sinngemäß auf weitere anwendbar. Beispielsweise sind für die Stellelemente A1 bis A4 (FIG. 1) beliebige Verstärker, z. B. Tansistoren (Dual-Gate-FET, HEMT, MESFET, Bipolar, HETERO-bipolar und andere), verwendbar. In diesen Fällen muß dann lediglich der anhand der FIG. 2 erläuterte Zusammenhang zwischen den Steuerspannungen U1, U2 und dem gewählten Verstärkertyp entsprechend angepaßt werden.

Ebenfalls können als Stellenelemente auch passiv wirkende Bauelemente, die als Dämpfungsglied verschaltet sind, verwendet werden. Beispielhaft seien PIN-Dioden, Varaktoren und spannungsabhängige Widerstände genannt.

**Patentansprüche**

1. Spannungsgesteuerte Anordnung zur Änderung der Amplitude eines Eingangssignals in Abhängigkeit von wenigstens einer Steuerspannung mit von der Steuerspannung ansteuerbaren Stellelementen, wobei

   - mindestens vier gleiche Stellelemente (A1 bis A4) vorhanden sind, wobei jeweils zwei Stellelemente (A1, A2 sowie A3, A4) zu einem Paar (PA1, PA2) zusammengefaßt sind, so daß jedes Paar (PA1, PA2) jeweils ein erstes Stellelement (A1, A3) sowie jeweils ein zweites Stellelement (A2, A4) enthält,
   - jeweils der Steuereingang (G1, G3) des ersten Stellelementes (A1, A3) eines Paares (PA1, PA2) mit dem Steuereingang des zweiten Stellelementes (A4, A2) des anderen Paares (PA2, PA1) verbunden ist und an jeweils eine Steuerspannung (U1, U2) angeschlossen ist,

   dadurch gekennzeichnet,
   daß bei den zu jedem Paar (PA1, PA2) gehörenden Stellelementen (A1, A2 sowie A3, A4) die Anschlüsse (D1, D2 bzw. D3, D4), an denen Ausgangssignale entstehen, miteinander und mit dem zugehörigem Signalausgang (P2, P3) verbunden sind, und daß ein Signaleingang (P1) über Koppelelemente (C1, C2) mit den Steuereingängen (G1, G3) der ersten Stellelemente (A1, A2) verbunden ist.

2. Spannungsgesteuerte Anordnung nach Anspruch 1, dadurch gekennzeichnet, daß die Stellelemente (A1 bis A4) im wesentlichen gleiche parasitäre Eigenschaften besitzen.

3. Spannungsgesteuerte Anordnung nach Anspruch 1 oder Anspruch 2, dadurch gekennzeichnet, daß die Stellelemente (A1 bis A4) als Verstärker ausgebildet sind.

4. Spannungsgesteuerte Anordnung nach einem der vorherigen Ansprüche, dadurch gekennzeichnet, daß die Stellelemente (A1 bis A4) als Halbleiterbauelemente ausgebildet sind.

5. Spannungsgesteuerte Anordnung nach einem der vorherigen Ansprüche, dadurch gekennzeichnet, daß die Stellelemente (A1 bis A4) als Feldeffekttransistoren ausgebildet sind.

6. Spannungsgesteuerte Anordnung nach einem der vorherigen Ansprüche, dadurch gekennzeichnet, daß die Stellelemente (A1 bis A4) als Feldeffekttransistoren für das X-Band ausgebildet sind.

7. Spannungsgesteuerte Anordnung nach einem der vorherigen Ansprüche, dadurch gekennzeichnet, daß die Eingangsadmittanz an dem Signaleingang (P1) und die Ausgangsadmittanz an einem Signalausgang (P2) in dem verwendeten Frequenzbereich im wesentlichen konstant sind dadurch, daß die Steuerspannungen U1, U2 entsprechend der Formel $U2 = Up - U1$ gewählt sind, wobei Up die Abschnürspannung eines Feldeffekttransistors bedeutet.

8. Spannungsgesteuerte Anordnung nach einem der vorherigen Ansprüche, dadurch gekennzeichnet,

   - daß die Steuerspannungen (U1, U2) mit Hilfe eines invertierenden Verstärkers (G1) und eines nichtinvertierenden Verstärkers (G2) erzeugt sind;

   - daß die Eingänge der Verstärker (G1, G2) durch ein Widerstandsnetzwerk (R1 bis R6) verbunden sind, und

   - daß das Widerstandsnetzwerk (R1 bis R6) durch eine digital einstellbare Spannungsquelle (D_Up, DA) einstellbar ist.

9. Spannungsgesteuerte Anordnung nach Anspruch 8, dadurch gekennzeichnet, daß die digital einstellbare Spannungsquelle eine einstellbare Spannungsquelle (D_Up), die auf die Abschnürspannung der für die Stellelemente (A1 bis A4) verwendeten Feldeffekttransistoren einstellbar ist, sowie einen Digital/Analog-Wandler (DA), mit welchem die Steuerspannungen (U1, U2) aus der Abschnürspannung erzeugt werden, enthält.

10. Spannungsgesteuerte Anordnung nach einem der vorherigen Ansprüche, dadurch gekennzeichnet, daß die Schaltungsanordnung als monolithisch integrierte Schaltungsanordnung aufgebaut ist.

11. Spannungsgesteuerte Anordnung nach einem der vorherigen Ansprüche zur Verwendung als spannungsgesteuerter Verstärker in einer phasengesteuerten Antenne.

**Claims**

1. Voltage-controlled arrangement for changing the amplitude of an input signal in dependence on at least one control voltage with setting elements controllable by the control voltage, wherein

   - at least four like setting elements (A1 to A4) are present, wherein each time two setting elements (A1, A2 as well as A3, A4) are combined into a pair (PA1, PA2), so that each pair (PA1, PA2) comprises a respective first setting element (A1, A3) as well as a respective second setting element (A2, A4),
   - the control input (G1, G3) of the first setting element (A1, A3) of a pair (PA1, PA2) is connected with the control input of the second setting element (A4, A2) of the respective other pair (PA2, PA1) and a respective control voltage (U1, U2) is applied thereto,

   characterised in that in the case of the setting elements (A1, A2 as well as A3, A4) belonging to each pair (PA1, PA2) the terminals (D1, D2 or D3, D4) at which the output signals thereof arise are connected with each other and with the associated signal output (P2, P3), and that a signal input (P1) is connected with the control inputs (G1, G3) of the first setting elements (A1, A2) by way of coupling elements (C1, C2).

2. Voltage-controlled arrangement according to claim 1, characterised in that the setting elements (A1 to A4) possess substantially the same parasitic characteristics.

3. Voltage-controlled arrangement according to claim 1 or claim 2, characterised in that the setting elements (A1 to A4) are constructed as amplifiers.

4. Voltage-controlled arrangement according to one of the preceding claims, characterised in that the setting elements (A1 to A4) are constructed as semiconductor elements.

5. Voltage-controlled arrangement according to one of the preceding claims, characterised in that the setting elements (A1 to A4) are constructed as field effect transistors.

6. Voltage-controlled arrangement according to one of the preceding claims, characterised in that the setting elements (A1 to A4) are constructed as field effect transistors for the X band.

7. Voltage-controlled arrangement according to one of the preceding claims, characterised in that the input admittance at the signal input (P1) and the output admittance at one signal output (P2) are substantially constant in the frequency range used in that the control voltages (U1, U2) are selected in correspondence with the formula U2 = Up - U1 , wherein Up signifies the cut-off voltage of a field effect transistor.

8. Voltage-controlled arrangement according to one of the preceding claims, characterised in that

   - the control voltages (U1, U2) are produced with the aid of an inverting amplifier (G1) and a noninverting amplifier (G2);
   - the inputs of the amplifiers (G1, G2) are connected by a resistance network (R1 to R6); and
   - the resistance network (R1 to R6) is settable by a digitally settable voltage source (D_Up, DA).

9. Voltage-controlled arrangement according to claim 8, characterised in that the digitally settable voltage source comprises a settable voltage source (D_Up), which is settable to the cut-off voltage of the field effect transistors used for the setting elements (A1 to A4), as well as a digital-to-analog converter (DA) by which the control voltages (U1, U2) are produced from the cut-off voltage.

10. Voltage-controlled arrangement according to one of the preceding claims, characterised in that the circuit arrangement is constructed as a monolithically integrated circuit arrangement.

11. Voltage-controlled arrangement according to one of the preceding claims for use as a voltage-controlled amplifier in a phase-controlled antenna.

**Revendications**

1. Dispositif commandé en tension pour modifier l'amplitude d'un signal d'entrée en fonction d'au moins une tension de commande, comportant des éléments de réglage pouvant être commandés par la tension de commande, dans lequel

   - il est prévu au moins quatre éléments de réglage identiques (A1 à A4), deux éléments de réglage (A1, A2 ainsi que A3, A4) étant respectivement rassemblés pour former un couple (PA1, PA2) de sorte que chaque couple (PA1,PA2) contient respectivement un premier élément de réglage (A1,A3) ainsi que respectivement un second élément de réglage (A2,A4),

- l'entrée respective de commande (G1,G3) du premier élément de réglage (A1,A3) d'un couple (PA1,PA2) étant reliée à l'entrée de commande du second élément de réglage (A4,A2) de l'autre couple (PA2,PA1) et étant raccordée à une tension de commande respective (U1,U2),

caractérisé en ce
que dans les éléments de réglage (A1,A2 ainsi que A3,A4) faisant partie de chaque couple (PA1,PA2), les bornes (D1,D2 ou D3,D4), sur lesquelles des signaux de sortie apparaissent, sont reliées entre elles et à la sortie associée de signal (P2,P3) et qu'une entrée de signal (P1) est reliée par l'intermédiaire d'éléments de couplage (C1,C2) aux entrées de commande (G1,G3) des premiers éléments de réglage (A1,A2).

2. Dispositif commandé en tension selon la revendication 1, caractérisé en ce que les éléments de réglage (A1 à A4) possèdent des caractéristiques parasites sensiblement identiques.

3. Dispositif commandé en tension selon la revendication 1 ou la revendication 2, caractérisé en ce que les éléments de réglage (A1 à A4) sont agencés sous la forme d'amplificateurs.

4. Dispositif commandé en tension selon l'une des revendications précédentes, caractérisé en ce que les éléments de réglage (A1 à A4) sont agencés sous la forme de composants à semiconducteurs.

5. Dispositif commandé en tension selon l'une des revendications précédentes, caractérisé en ce que les éléments de réglage (A1 à A4) sont agencés sous la forme de transistors à effet de champ.

6. Dispositif commandé en tension selon l'une des revendications précédentes, caractérisé en ce que les éléments de réglage (A1 à A4) sont agencés sous la forme de transistors à effet de champ pour la bande X.

7. Dispositif commandé en tension selon l'une des revendications précédentes, caractérisé en ce que l'admittance d'entrée au niveau de l'entrée de signal (P1) et l'admittance de sortie au niveau d'une sortie de signal (P2) sont sensiblement constantes dans la gamme de fréquences utilisée par le fait que les tensions de commande U1, U2 sont choisies conformément à la formule $U2 = Up - U1$, $Up$ étant la tension de blocage d'un transistor à effet de champ.

8. Dispositif commandé en tension selon l'une des revendications précédentes, caractérisé en ce

- que les tensions de commande (U1,U2) sont produites à l'aide d'un amplificateur inverseur (G1) et d'un amplificateur non inverseur (G2);
- que les entrées des amplificateurs (G1,G2) sont reliées par un réseau de résistances (R1 à R6), et
- que le réseau de résistances (R1 à R6) est réglable au moyen d'une source de tension réglable numériquement (D_Up, DA).

9. Dispositif commandé en tension selon la revendication 8, caractérisé en ce que la source de tension réglable numériquement contient une source de tension réglable (D_Up), qui est réglable sur la tension de blocage des transistors à effet de champ utilisés pour les éléments de réglage (A1 à A4), ainsi qu'un convertisseur numérique/analogique (DA), à l'aide duquel les tensions de commande (U1,U2) sont produites à partir de la tension de blocage.

10. Dispositif commandé en tension selon l'une des revendications précédentes, caractérisé en ce que le montage est constitué sous la forme d'un montage intégré monolithique.

11. Dispositif commandé en tension selon l'une des revendications précédentes, pour son utilisation en tant qu'amplificateur commandé en tension dans une antenne pilotée en phase.

Fig. 1

Fig. 2

Fig. 3